# EUROPÄISCHE PATENTSCHRIFT

(11) **EP 4 646 608 B1**
(45) Veröffentlichungstag und Bekanntmachung des Hinweises auf die Patenterteilung: **04.11.2026**
(21) Anmeldenummer: 24702248.6
(22) Anmeldetag: 17.01.2024
(51) Int. Cl.: G01S 7/40, G01R 31/308, G01S 13/88, G01S 17/88, H02H 5/00, G01S 7/497

(54) **VERSCHMUTZUNGSERKENNUNG BEI ELEKTRISCHEN BAUGRUPPEN MITTELS RADAR-TECHNOLOGIE**
DETECTION OF ELECTRICAL COMPONENT CONTAMINATION USING RADAR TECHNOLOGY
DÉTECTION DE SALISSURES DANS DES MODULES ÉLECTRIQUES AU MOYEN DE LA TECHNOLOGIE RADAR

(30) Priorität: 24.02.2023 EP 23158536
(43) Veröffentlichungstag der Anmeldung: 12.11.2025
(73) Patentinhaber: Siemens Aktiengesellschaft, 80333 München (DE)
(72) Erfinder: ZETTNER, Jürgen, 90587 Veitsbronn (DE)
(74) Vertreter: Siemens Patent Attorneys
(86) Internationale Anmeldenummer: PCT/EP2024/051011
(87) Internationale Veröffentlichungsnummer: WO 2024/175273

(56) Entgegenhaltungen:
- WO-A1-02/067002
- DE-A1- 102017 222 618
- DE-A1- 19 945 250

## Beschreibung

Die Erfindung betrifft ein Verfahren zum Überwachen einer elektrischen Baugruppe hinsichtlich Verschmutzung. Ferner betrifft die Erfindung eine Vorrichtung zum Überwachen einer elektrischen Baugruppe hinsichtlich Verschmutzung.

Verschmutzung auf elektrischen Baugruppen stellt insbesondere in staubigen Umgebungen, wie sie in der Zementindustrie, im Bergbau etc. vorkommen, aber auch in vielen anderen industriellen Umgebungen ein Problem dar. Auch im maritimen Umfeld können Rückstände zu Schäden führen.

Besonders problematisch sind leitfähige Ablagerungen wie Ruß oder Salz, die insbesondere Kurzschlüsse bei elektrischen, insbesondere elektronischen Baugruppen auslösen können.

Generell führen starke Verschmutzungen zu elektrischen Problemen wie Kriechstrecken oder Störungen bei hochohmigen Signalpfaden sowie thermischen Problemen (schlechtere Entwärmung), die bis hin zum Ausfall elektrischer Baugruppen und damit oftmals ganzer Geräte führen können.

Häufig sind Verschmutzungen in geschlossenen Gehäusen nur schwer bzw. mit hohem Aufwand zu erkennen, z.B. durch:
Optische Inspektion - jedoch aufwendig und in der Regel nicht im Betrieb möglich. Das Gerät muss dazu geöffnet werden.
Indirekt über eine steigende Bauteiltemperatur - ein derartiges Monitoring ist nicht überall möglich und liefert auch nur ein Indiz. Eine erhöhte Bauteiltemperatur kann auch betriebsbedingte Ursachen haben.
Zusätzliche Sensorik zur Detektion von Ablagerungen, z.B. optisch, resistiv oder kapazitiv auf einer Platine - diese benötigt Platz, deckt nicht die gesamte Baugruppe ab und insb. bei Hochvoltbaugruppen ist eine aufwendige Potentialtrennung nötig.

Es ist ferner bekannt, die Auswirkungen von Verschmutzung durch "conformal coating" oder "Verguss" zu reduzieren.

Die Patentschrift DE 10 2004 018 578 B4 beschreibt eine Messung der Oberflächenleitfähigkeit zur Erfassung des Verschmutzungsgrades einer elektronischen Baugruppe. Diese Vorgehensweise ist stark von der Art und insbesondere der Leitfähigkeit der Schmutzpartikel abhängig und daher häufig nicht zielführend.

Aus der Veröffentlichung Pohl, Nils & Jaeschke, Timo & Scherr, Steffen & Ayhan, Serdal & Pauli, M. & Zwick, Thomas & Musch, Thomas: "Radar measurements with micrometer accuracy and nanometer stability using an ultra-wideband 80 GHz radar system", 31-33. 10.1109/WiSNet.2013.6488624, ist ein hochpräzises 80-GHz-Radar Entfernungsmesssystem bekannt. Dieses basiert auf einem ultra-breitbandigen monostatischen SiGe-Transceiver-Chip, der eine Bandbreite von 25,6 GHz um eine Mittenfrequenz von 80 GHz (d.h. 32%) ermöglicht. Alle Komponenten außer dem Silizium-Radarchip sind handelsübliche Elektronik, so dass der Sensor gut für kostengünstige industrielle Messanwendungen geeignet ist.

Aus der WO02067002A1 sind ein Verfahren und eine Vorrichtung zum Prüfen von elektronischen Schaltungen oder deren Teilen auf Leiterplatten bekannt. Dabei sind folgende Verfahrensschritte vorgesehen, welche eine berührungslose Prüfung bei einfachen Aufbau der Vorrichtung erzielen: a) Erfassen einer von einer Oberfläche der Leiterplatte ausgehenden Strahlung, b) Umsetzen der erfassten Strahlung in Daten, welche eine Oberflächenstruktur und/oder Tiefenstruktur der Leiterplatte repräsentieren, c) Vergleichen der Daten der Oberflächenstruktur und/oder der Tiefenstruktur mit gespeicherten Daten eines Sollzustandes der Oberflächenstruktur und/oder Tiefenstruktur und d) Bestimmen von Abweichungen zwischen den Daten der erfassten Oberflächenstruktur und/oder Tiefenstruktur und den Daten des Sollzustandes der Oberflächenstruktur und/oder Tiefenstruktur.

Aus der DE19945250A1 sind ein Verfahren und eine Vorrichtung zur Zustandserkennung bei einem System zur automatischen Längs- und/oder Querregelung bei einem Kraftfahrzeug bekannt, die nach dem Radarprinzip und/oder dem Lidarprinzip arbeiten. Sie dienen zur Verschmutzungs- und/oder Blindheitserkennung eines Sensors, wobei die Zustandserkennung von wenigstens zwei Indikatoren (In) abhängig ist, die aus den von dem Sensor empfangenen und/oder ausgesendeten Signalen gebildet werden. Dabei werden die wenigstens zwei Indikatoren (In) mit Wichtungsfaktoren (an) gewichtet und die gewichteten Indikatoren zu einer einzigen Wahrscheinlichkeit (V) verknüpft, die eine Aussage über den wahrscheinlichen Zustand (P) des Systems macht.

In der DE102017222618A1 wird ein LiDAR- (light detection and ranging-) System mit integrierter Verschmutzungserkennung beschrieben, umfassend: eine Sendeeinheit, dazu ausgebildet, elektromagnetische Strahlung gerichtet in die Umgebung des LiDAR-Systems abzustrahlen; eine Empfängereinheit, dazu ausgebildet, einen aus der Umgebung des LiDAR-Systems in das LiDAR-System zurückgestreuten Anteil der von der Sendeeinheit abgestrahlten elektromagnetischen Strahlung zu detektieren; ein Austrittsfenster, dazu ausgebildet, das LiDAR-System zumindest in Abstrahlrichtung der Sendeeinheit von der Umgebung abzugrenzen, wobei die von der Sendeeinheit abgestrahlte elektromagnetische Strahlung durch das Austrittsfenster in die Umgebung transmittiert wird; wobei das LiDAR-System weiterhin einen Verschmutzungssensor umfasst, dazu ausgebildet, einen an einer Oberfläche des Austrittsfensters in das LiDAR-System zurückgestreuten Anteil der von der Sendeeinheit abgestrahlten elektromagnetischen Strahlung zu detektieren. Kommerziell weit verbreitet und damit kostengünstig sind Radar-ICs **z.B.** im Automotive-Bereich, insbesondere bei Einparkhilfen.

Begünstigt durch höhere Integration einzelner Baugruppen können komplette Radargeräte (nachfolgend auch kurz als "Radar" bezeichnet) heute als kleinste Module bzw. Integrierte Schaltungen (ICs) aufgebaut werden.

Eine Aufgabe der vorliegenden Erfindung ist es, die Verschmutzungserkennung bei elektrischen Baugruppen zu vereinfachen und zu verbessern.

Diese Aufgabe wird gelöst durch ein Verfahren mit den in Patentanspruch 1 angegebenen Verfahrensschritten, also durch ein Verfahren zum Überwachen einer elektrischen Baugruppe hinsichtlich Verschmutzung mittels eines Radars, wobei
- eine Radarsignalerzeugungseinrichtung ein Radarsignal erzeugt und mittels einer Radarsignalsendeeinrichtung in Richtung einer von der elektrischen Baugruppe umfassten Oberfläche aussendet,
- wobei das Radarsignal an der Oberfläche oder einem auf der Oberfläche befindlichen Objekt reflektiert wird,
- wobei eine Radarsignalempfangseinrichtung ein reflektiertes Radarsignal empfängt und wobei
- eine Radarsignalauswerteeinrichtung das von der Radarsignalempfangseinrichtung empfangene, reflektierte Radarsignal auswertet zum Erkennen einer bei der elektrischen Baugruppe vorliegenden Verschmutzung,
- wobei das Radar nicht von der elektrischen Baugruppe umfasst ist,
- wobei das Radar über eine Datenverbindung mit einer externen Recheneinrichtung verbunden ist, mittels der die von dem Radar erzeugten Daten empfangen, gespeichert und gegebenenfalls weiterverarbeitet werden,
- wobei die Verschmutzung der elektrischen Baugruppe über einen längeren Zeitraum, insbesondere Jahre, registriert und analysiert wird und
- die elektrische Baugruppe im laufenden Betrieb hinsichtlich Verschmutzung überprüft wird.

Das Grundprinzip der Radar-Technik (Funkmesstechnik) ist seit langem bekannt: eine Radarsignalerzeugungseinrichtung, insbesondere ein (digitaler) Signalprozessor, erzeugt ein (zunächst elektrisches) (Radar-) Signal. Eine Radarsignalsendeeinrichtung und insbesondere wenigstens eine davon umfasste Sendeantenne strahlt dieses in Form eines elektromagnetischen (HF-) Radarsignals (Sendesignals) in Richtung eines Objekts, z.B. eines Fahrzeuges, eines Flugzeuges oder eines Schiffes. Das Objekt reflektiert das gesendete Sendesignal und eine Radarsignalempfangseinrichtung (Radarempfänger bzw. Empfangseinheit) erfasst das von dem Objekt reflektierte Radarsignal (Empfangssignal). Hierbei umfasst die Radarsignalempfangseinrichtung wenigstens eine Empfangsantenne. Als Sende- bzw. Empfangsantenne(n) kann auch dieselbe Antenne bzw. können auch dieselben Antennen verwendet werden, die somit sowohl das Sendesignal aussenden als auch das reflektierte Empfangssignal empfangen. Eine Radarsignalauswerteeinrichtung (Auswerteelektronik), insbesondere ein (digitaler) Signalprozessor, wertet schließlich das empfangene Signal (Empfangssignal bzw. Echo) aus. Insbesondere werden die Laufzeit zwischen dem gesendeten Signal (Sendesignal) und dem empfangenen Echo (Empfangssignal) und die Signalstärke des Echos, gegebenenfalls auch die Phasenlage der beiden Signale gemessen. So ist es möglich, über eine bestimmte Entfernung zu dem Objekt und insbesondere "drahtlos" eine Reihe an Eigenschaften des Objekts zu erfassen bzw. zu bestimmen, wie z.B. seine Entfernung zum Radar, seine Größe, seine Geschwindigkeit relativ zu dem Radar, seine Oberflächenbeschaffenheit etc.

Erfindungsgemäß wird das oben skizzierte Grundprinzip nun dazu verwendet, um Verschmutzungen an elektrischen (insbesondere elektronischen) Baugruppen zu erkennen.

Insbesondere nutzt ein erfindungsgemäßer "Verschmutzungs-sensor" die Eigenschaft von Millimeter-Radarwellen, welche an leitfähigen Stoffen gut reflektiert werden und an dicken organischen Stoffen oder Wasser - mit der Dicke korreliert - absorbiert werden.

Unter einer elektrischen Baugruppe ist im Zusammenhang mit der Erfindung insbesondere jedes elektrische Gerät (z.B. ein elektrischer Motor, ein Umrichter etc.) oder jeder Teil eines elektrischen Gerätes zu verstehen, der eine Einheit bildet, z.B. eine Platine, ein Netzteil etc. Insbesondere ist darunter auch eine elektronische Baugruppe zu verstehen, also eine Ansammlung elektronischer Bauelemente (Dioden, Transistoren, ICs etc.), die zur Erfüllung eines bestimmten Zwecks (Stromversorgung, Datenverarbeitung etc.) miteinander verschaltet sind.

Da Radargeräte preiswert und in kleiner Bauform (z.B. Radar-ICs) am Markt verfügbar sind, lassen sich erfindungsgemäß elektrische Baugruppen einfach und kostengünstig hinsichtlich Verschmutzung überwachen. Allgemein werden so sich auf der Oberfläche der elektrischen Baugruppen ansammelnde und möglicherweise Störungen verursachende Objekte, insbesondere Verunreinigungen bzw. Schmutz jeglicher Form (fest, staubartig, körnig, flüssig etc.), erkannt.

Die von dem Radargerät erzeugten Signale bzw. Daten lassen sich vorzugsweise vorteilhaft aus dem Radargerät auslesen und weiterleiten zur weiteren Datenverarbeitung in einer Recheneinrichtung. Die Recheneinrichtung kann dabei von dem zu überwachenden Gerät umfasst sein, es kann sich aber auch um eine aus Sicht des Gerätes externe Recheneinrichtung handeln. So kann der Grad der Verschmutzung beispielsweise über einen längeren Zeitraum beobachtet und ggf. angemessen darauf reagiert werden, z.B. indem frühzeitig eine Warnmeldung vor einem drohenden Ausfall der elektrischen Baugruppe wegen Verschmutzung erzeugt wird.

Die Signalauswertung zum Erkennen von Schmutz bzw. Verschmutzung kann jedoch auch in dem Radargerät selbst erfolgen. Es verfügt dazu über eine geeignete Rechen- bzw. Datenverarbeitungseinrichtung, auch als Auswerteelektronik bezeichnet, insbesondere einen (digitalen) Signalprozessor.

Eine Ausführungsform der Erfindung sieht vor, dass mittels der Auswerteelektronik ein Vergleich mit Referenzdaten der unverschmutzten Oberfläche der elektrischen Baugruppe erfolgt. Dazu werden insbesondere die von dem Radargerät erzeugten Daten bei der Inbetriebnahme des zu diesem Zeitpunkt unverschmutzten Gerätes gespeichert, so dass Referenzdaten bezüglich der "sauberen" zu überwachenden elektrischen Baugruppe vorhanden sind.

Aus dem Vergleich der aktuellen Daten mit den entsprechend zuvor erzeugten Referenzdaten kann schnell und zuverlässig eine Veränderung registriert und darauf reagiert werden. Auch lassen sich mittels Aufzeichnung der erzeugten Daten über einen längeren Zeitraum darauf aufbauend Prognosen für die Zukunft erstellen und ggf. frühzeitig darauf reagieren.

Insbesondere aus dem Vergleich mit Messungen an der unverschmutzten elektrischen Baugruppe lassen sich so Erkenntnisse über den Umfang und die Art der Verschmutzung gewinnen.

Weiterhin lässt sich anhand des Vergleichs mit Referenzdaten vorteilhaft auch die Dicke einer detektierten Schmutzschicht ermitteln.

Bezüglich des Typs des verwendeten Radars bestehen prinzipiell keine Einschränkungen. In Frage kommen jedoch vor allem als UWB-Radar (Ultra-Breitband- bzw. engl. ultra-wideband-radar), mm- bzw. HF-Radar oder als Infrarot-Radar ausgebildete Varianten, da diese als zuverlässige und kostengünstige Geräte und insbesondere in kleiner Bauform am Markt vorhanden sind. Der spezielle, jeweils zur Anwendung kommende Gerätetyp kann auch abhängig von der Art der zu erwartenden Verschmutzung und dem verfügbaren Bauraum ausgewählt werden.

Insbesondere bei Verwendung eines UWB- (ultra wideband-) Radars mit einer Auflösung im Sub-Millimeter-Bereich lassen sich so bereits geringfügige Verschmutzungen an Bauteil-Oberflächen feststellen.

Vorteilhaft arbeitet die Sende- und Empfängereinheit mit einer Frequenz des gesendeten Signals von mindestens 60GHz, wobei das zu überwachende, verschmutzungsanfällige Bauteil mit Millimeter-Wellen bestrahlt wird und die zurückreflektierte HF-Strahlung mittels einer oder mehrerer (Empfangs-) Antennen empfangen und die frequenzabhängige Signalstärke und/oder deren Phasenlage ausgewertet werden.

Unter Auswertung von Phasenlagen sind damit sogar Auflösungen im Mikrometer-Bereich erzielbar.

Radar-ICs, die im mm-HF Wellenlängenbereich arbeiten, besitzen sowohl eine gute Ortsauflösung (über z.B. 4 integrierte Antennen), als auch einen gewissen "durchstimmbaren" Frequenzumfang, so dass mit einem derartigen Sensor sowohl eine Lokalisierung einer Verschmutzung möglich ist, als auch eine frequenzabhängige HF-Feldstärke ausgewertet werden kann, welche z.B. für gewisse Verschmutzungsstoffe charakteristisch ist, so dass eine Eingrenzung der Art bzw. Zusammensetzung der Verschmutzung ("Fingerprint") erfolgen kann.

Die einzelnen Komponenten des Radargerätes (Radars), also die Radarsignalerzeugungseinrichtung, die Radarsignalsendeeinrichtung, die Radarsignalempfangseinrichtung, die Sende- und/oder Empfangsantenne(n) und die Radarsignalauswerteeinrichtung, mitunter auch als Sende- und Empfangseinheit, Antennen und Auswerteelektronik bezeichnet, können als einzelne, diskrete Bauteile ausgebildet bzw. aus einzelnen, diskreten, miteinander verbundenen Bauteilen aufgebaut sein.

Aufgrund der zunehmenden Miniaturisierung in der Mikroelektronik ist es möglich, viele, vorzugsweise alle notwendigen Komponenten eines Radars in einem einzigen, kleinen Modul zu vereinen, welches beispielsweise direkt auf einer Platine einer elektrischen Baugruppe platziert werden kann. Darüber hinaus ist es möglich, mehrere, insbesondere alle Komponenten des Radargerätes in einem einzigen hochintegrierten Schaltkreis (IC) zu vereinen. Selbst die Integration der Antennen in den IC ist möglich.

Das Radargerät ist somit vorzugsweise einstückig ausgebildet oder es umfasst nur einige wenige Komponenten. Es bedarf daher auch nur einiger weniger Anschlüsse, z.B. zur Spannungsversorgung. Es lässt sich damit schnell und einfach an der dafür vorgesehenen Stelle, beispielsweise auf einer Platine oder in bzw. an einem Gehäuse eines Gerätes, platzieren.

Eine Ausführungsform der Erfindung sieht vor, dass sich das Radar nicht auf der zu überwachenden elektrischen Baugruppe selbst, sondern entfernt von der zu überwachenden elektrischen Baugruppe befindet. Das Radar ist demnach bei dieser Ausführungsform nicht von der zu überwachenden elektrischen Baugruppe umfasst. Insbesondere kann sich das Radar beispielsweise auf einer weiteren elektrischen Baugruppe des Gerätes, welches hinsichtlich Verschmutzung überwacht wird, oder an oder in einem die elektrische Baugruppe umgebenden Gehäuse bzw. Schaltschrank befinden. Die zu überwachende elektrische Baugruppe und das Radar werden jedoch vorzugsweise in geringem Abstand zueinander angeordnet, beispielsweise innerhalb desselben Gehäuses.

Diese Ausführungsform hat den Vorteil, dass das Radar an einer vor Verschmutzung weniger gefährdeten Stelle des Gerätes mit der zu überwachenden elektrischen Baugruppe angebracht werden kann und damit selbst besser vor Verschmutzung geschützt ist.

Neben der Radartechnik kann das verwendete Radargerät zum Erkennen von Verschmutzungen auch auf weitere (Sensor-) Techniken zurückgreifen, um die Art bzw. Zusammensetzung der betreffenden Verschmutzung genauer eingrenzen zu können. Insbesondere weist das Radargerät vorteilhaft Mittel zum Messen eines elektrischen Widerstandes an der Oberfläche des Radars auf, insbesondere mehrere voneinander beabstandete Elektroden, zwischen denen eine elektrische Spannung angelegt und dadurch mittels Strommessern (Amperemeter) der elektrische Widerstand zwischen den Elektroden gemessen werden kann. Dadurch ist es möglich, elektrisch leitfähige Verschmutzungen, die in der Regel als besonders kritisch anzusehen sind, noch sicherer zu detektieren, als dies bei alleiniger Anwendung der Radartechnik der Fall wäre.

Erfindungsgemäß platziert man den Radar-IC vorteilhaft derart, dass die zu überwachende verschmutzungsanfällige Platine mit Millimeter-Wellen bestrahlt wird und die zurückreflektierte HF-Strahlung mittels einer oder mehrerer Antennen empfangen und die frequenzabhängige Signalstärke des reflektierten Radarsignals und/oder dessen Phasenlage (in Bezug auf das gesendete Radarsignal) ausgewertet wird. Unter Auswertung von Phasenlagen sind heute bereits Mikrometer-Auflösungen erzielbar.

Radar-ICs, die im mm-HF Wellenlängenbereich arbeiten, besitzen sowohl eine grobe Ortsauflösung (über z.B. 4 integrierte Antennen), als auch einen gewissen durchstimmbaren Frequenzumfang, so dass mit der erfindungsgemäßen Radar-Anwendung sowohl eine grobe Lokalisierung möglich ist als auch eine frequenzabhängige HF-Feldstärke ausgewertet werden kann, welche z.B. für gewisse Verschmutzungsstoffe charakteristisch ist ("Fingerprint"), so dass eine Eingrenzung der Art der Verschmutzung erfolgen kann.

Die Vorteile der Erfindung liegen insbesondere bei der berührungslosen, potentialgetrennten Erfassung von leitfähigen Verschmutzungen.

Weitere Vorteile der Erfindung sind:
- Durch die berührungslose Messung entfällt - insbesondere bei Hochvoltbaugruppen - eine aufwendige Potentialtrennung;
- Radar-ICs sind robust gegen Umwelteinflüsse und können nichtleitfähige Materialen gut durchstrahlen. Durch den großen Unterschied hinsichtlich der Signalstärke der reflektierten Strahlung kann im Allgemeinen einfach zwischen leitfähigen und nicht leitfähigen Ablagerungen unterschieden werden. Radar-ICs können so auch zur Stoffdetektion (Fingerprint) verwendet werden;
- Die Erfindung ermöglicht ein Online-Monitoring im laufenden Betrieb einer hinsichtlich Verschmutzung zu überprüfenden elektrischen Baugruppe;
- Die Stoffcharakteristik und damit die Zusammensetzung unterschiedlicher Verschmutzungen ist ermittelbar;
- Ein abgeleitetes Maß mit Korrelation zur Leitfähigkeit und/oder der Dicke der Verschmutzung ist ermittelbar.

Die Erfindung wird nachfolgend anhand von Ausführungsbespielen exemplarisch näher beschrieben und erläutert. Dabei zeigen:
- FIG 1: ein erstes Ausführungsbeispiel zur Überwachung einer elektrischen Baugruppe mittels eines Radars,
- FIG 2: ein zweites Ausführungsbeispiel zur Überwachung einer elektrischen Baugruppe mittels eines Radars,
- FIG 3: Verfahrensschritte bei der Durchführung eines erfindungsgemäßen Verfahrens.

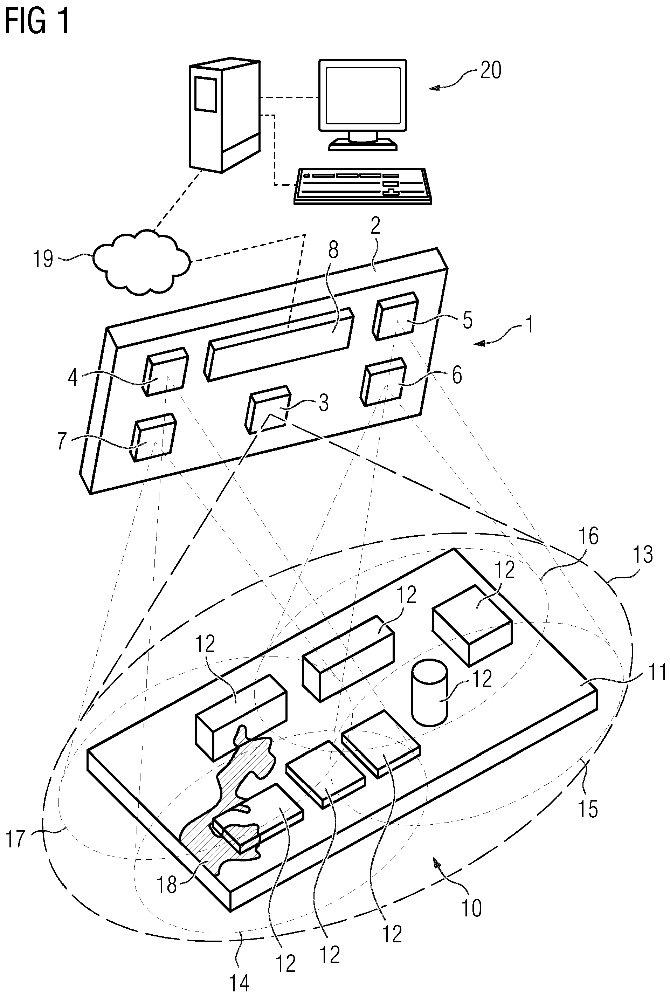

FIG 1 zeigt eine elektrische Baugruppe 10 in Form einer mit mehreren elektrischen und elektronischen Bauelementen 12 bestückten Platine 11. Die elektrische Baugruppe 10 befindet sich in einer vor Verschmutzung gefährdeten Umgebung, z.B. in einer industriellen Umgebung der Zement- oder chemischen Industrie.

Erfindungsgemäß wird die elektrische Baugruppe 10 durch ein Radargerät (Radar) 1 bezüglich Verschmutzung überwacht. Dabei sind auf einem Modulträger, z.B. einer Platine 2 des Radars 1, alle wesentlichen Komponenten des Radars 1 angebracht. Zu diesen Komponenten zählen: eine Sendeantenne 3, vier Empfangsantennen 4-7 sowie ein Signalprozessor 8. Der Signalprozessor 8 umfasst in einem IC integriert wenigstens teilweise eine Radarsignalerzeugungseinrichtung, eine Radarsignalsendeeinrichtung (Radarsender), eine Radarsignalempfangseinrichtung (Radarempfänger) sowie eine Radarsignalauswerteeinrichtung (Auswerteelektronik). Dabei kann die Sendeantenne 3 der Radarsignalsendeeinrichtung und können die Empfangsantennen 4-7 der Radarsignalempfangseinrichtung zugeordnet sein.

Es ist auch möglich, dass alle gezeigten bzw. genannten Komponenten des Radars 1 in einem einzigen Radar-IC (nicht dargestellt) integriert sind.

Die Radarsignalerzeugungseinrichtung erzeugt im Ausführungsbeispiel ein mm-HF-Radarsignal, welches über den Radarsender und insbesondere die davon umfasste Sendeantenne 3 in Richtung der elektrischen Baugruppe 10 gesendet wird. Vorteilhaft wird der räumliche Sendebereich 13 dabei so gewählt, dass er die elektrische Baugruppe 10 vollständig abdeckt, das Sendesignal also alle Bereiche der elektrischen Baugruppe 10 erreicht. An der elektrischen Baugruppe 10 bzw. deren Komponenten 11 und 12 wird das Sendesignal reflektiert und als Echo bzw. Empfangssignal von den vier Empfangsantennen 4-7 des Radars 1 erfasst.

Jeder der vier Empfangsantennen 4-7 ist ein Bereich 14-17 der Oberfläche der elektrischen Baugruppe 10 zugeordnet, so dass sich ggf. der Bereich der Oberfläche der elektrischen Baugruppe 10, der von Verschmutzung betroffen ist, enger eingrenzen lässt. Im Ausführungsbeispiel wird dadurch erkannt, dass in dem der Empfangsantenne 4 zugeordneten Bereich 14 der elektrischen Baugruppe 10 Schmutzpartikel 18 vorhanden sind und somit in diesem Bereich eine Verschmutzung vorliegt.

Zum Erkennen einer Verschmutzung werden die von den Empfangsantennen 14-17 erfassten Empfangssignale - gegebenenfalls nach einer Signalumwandlung und/oder -aufbereitung in der Radarsignalempfangseinrichtung - analysiert. Insbesondere erfolgt dabei ein Vergleich mit in der Radarsignalauswerteeinrichtung hinterlegten, bezüglich der unverschmutzten elektrischen Baugruppe 10 erzeugten Empfangssignale bzw. Daten.

Im Ausführungsbeispiel gemäß FIG 1 ist das Radar 1 entfernt von der zu überwachenden elektrischen Baugruppe 10 angeordnet, also nicht an oder auf der zu überwachenden elektrischen Baugruppe, und ist vorzugsweise so platziert, insbesondere an oder in einem die elektrische Baugruppe 10 umgebenden Gehäuse (nicht dargestellt), dass es selbst in einem vor Verschmutzung weniger gefährdeten bzw. geschützten Bereich liegt.

Die Erfindung ist insbesondere dann von Vorteil, wenn ein Benutzer der elektrischen Baugruppe 10 rechtzeitig vor einer Verschmutzung gewarnt wird, bevor diese Schaden an der elektrischen Baugruppe 10 anrichtet, zum Beispiel in Form möglicher Kurzschlüsse oder Überhitzung. Dafür ist das Radar 1 im Ausführungsbeispiel über eine Datenverbindung, zum Beispiel das Internet 19, mit einer externen Recheneinrichtung, im Ausführungsbeispiel einem PC 20 verbunden. In dem PC 20 können die von dem Radar 1 erzeugten Daten empfangen, gespeichert und gegebenenfalls weiterverarbeitet werden. Insbesondere kann so die Verschmutzung der elektrischen Baugruppe 10 über einen längeren Zeitraum (zum Beispiel Jahre) registriert und analysiert werden. Vorteilhaft kann so ab einem bestimmten erkannten Maß an Verschmutzung eine Warnmeldung an einen Benutzer der elektrischen Baugruppe 10 abgegeben werden. Vorteilhaft wird dieser so rechtzeitig vor einem drohenden Ausfall der elektrischen Baugruppe 10 gewarnt, bevor dieser eintritt.

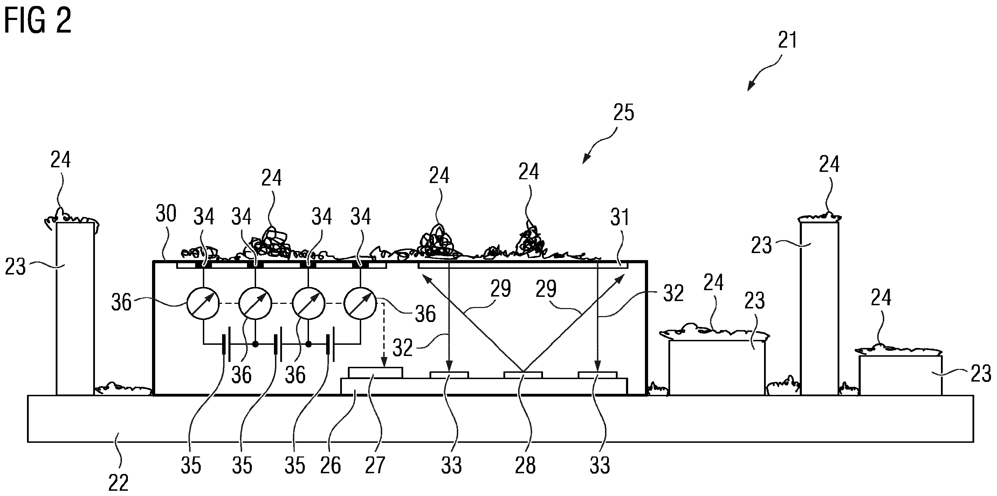

FIG 2 zeigt eine nicht von der Erfindung umfasste Vorrichtung. Auch hier wird eine elektrische Baugruppe 21 mittels eines Radars 25 auf Verschmutzung überwacht. Die elektrische Baugruppe 21 umfasst eine Platine 22, auf der eine Anzahl elektrischer, insbesondere elektronischer, insbesondere Halbleiter-Bauelemente angeordnet ist. Anders als bei dem Ausführungsbeispiel gemäß FIG 1 befindet sich bei diesem Ausführungsbeispiel das Radar 25 jedoch direkt auf der zu überwachenden elektrischen Baugruppe 21. Es ist daher selbst von Verschmutzung betroffen, sodass sich auch auf einer Oberfläche eines Gehäuses 30 des Radars 25 Schmutz 24 befindet.

Auch das Radar 25 umfasst eine Radarsignalerzeugungseinrichtung in Form eines Signalprozessors 27, der ein Radarsignal 29 erzeugt, welches mittels einer Radarsignalsendeeinrichtung, insbesondere einer davon umfassten Sendeantenne 28, in Richtung eines in dem Gehäuse 30 des Radars 25 befindlichen, für das Radarsignal 29 transparenten Bereiches 31 des Gehäuses 30 ausgesendet wird.

Wie aus FIG 2 ersichtlich, befindet sich (auch) in dem transparenten Bereich 31 des Gehäuses 30 der Oberfläche des Radars 25 Objekte in Form von Schmutz 24, an denen bzw. dem das Radarsignal 29 reflektiert wird. Das so entstandene reflektierte Radarsignal 32 (auch Empfangssignal oder "Echo" genannt) wird im Ausführungsbeispiel von mehreren Empfangsantennen 33, die Teil einer Radarsignalempfangseinrichtung sind, empfangen.

Die Radarsignalsendeeinrichtung und die Radarsignalempfangseinrichtung umfassen neben den bereits genannten Antennen in der Regel zumindest noch Signalwandler (nicht dargestellt), die das jeweilige Signal von einem elektrischen in ein elektromagnetisches Signal und umgekehrt wandeln.

Das Radar 25 umfasst weiterhin eine Radarsignalauswerteeinrichtung, die in dem Ausführungsbeispiel ebenfalls von dem Signalprozessor 27 umfasst ist und in der das von der Radarsignalempfangseinrichtung empfangene (reflektierte) Radarsignal ausgewertet wird zum Erkennen der bei der elektrischen Baugruppe 21 vorliegenden Verschmutzung in Form des Schmutzes 24.

Zum Erkennen einer Verschmutzung erfolgt auch hier vorzugsweise ein Vergleich mit in dem Signalprozessor 27 hinterlegten Daten, die zuvor anhand des nicht von Verschmutzung betroffenen Radars 25 gewonnen wurden.

Als weitere Besonderheit verfügt das Radar 25 gemäß FIG 2 über mehrere an der Oberfläche des Gehäuses 30 angebrachte, voneinander beabstandete und nicht direkt elektrisch miteinander verbundene Elektroden 34, zwischen denen mittels der Spannungsquellen 35 eine elektrische Spannung angelegt werden kann. Mittels ebenfalls vorhandener Strommesser 36 können zwischen den Elektroden 34 vorhandene (Kriech-) Ströme erfasst und entsprechende Signale dem Signalprozessor 27 zur weiteren Signalanalyse zugeführt werden. Dadurch wird es möglich, bestimmte Eigenschaften des Schmutzes 24 näher zu bestimmen. Insbesondere ist es dadurch möglich, die elektrische Leitfähigkeit des Schmutzes 24 zu ermitteln. Dies ist besonders vorteilhaft, da elektrisch leitfähiger Schmutz 24 zu elektrischen Kurzschlüssen bei der elektrischen Baugruppe 21 führen kann, was eine Beschädigung bis hin zum Ausfall der elektrischen Baugruppe 21 nach sich ziehen könnte. Der Signalprozessor 27 kann diese Daten mit in die Signalanalyse einbeziehen und in Abhängigkeit davon geeignete Maßnahmen ableiten, zum Beispiel eine Warnmeldung erzeugen oder die elektrische Baugruppe 21 abschalten.

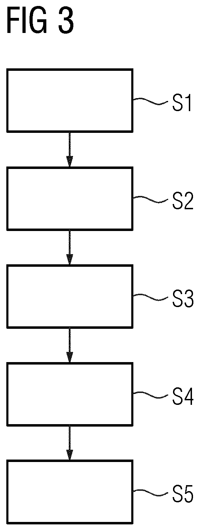

FIG 3 beschreibt nochmals die wesentlichen Verfahrensschritte bei der Durchführung eines erfindungsgemäßen Verfahrens zum Überwachen einer elektrischen Baugruppe hinsichtlich Verschmutzung mittels eines Radars.

In einem ersten Verfahrensschritt S1 wird mittels einer Radarsignalerzeugungseinrichtung, insbesondere einem Signalgenerator bzw. einem Signalprozessor, ein Radarsignal erzeugt.

In einem zweiten Verfahrensschritt S2 wird das in Verfahrensschritt 1 erzeugte Radarsignal mittels einer Radarsignalsendeeinrichtung, die wenigstens eine Sendeantenne zum Senden des erzeugten Radarsignals umfasst, in Richtung einer von der elektrischen Baugruppe umfassten Oberfläche ausgesendet. Anschließend wird das ausgesendete Radarsignal an der Oberfläche der elektrischen Baugruppe oder an wenigstens einem an der Oberfläche der elektrischen Baugruppe befindlichen Objekt, insbesondere Schmutz, reflektiert. Dabei hängt die Signalstärke des reflektierten Radarsignals bzw. dessen Phasenlage gegenüber dem gesendeten Radarsignal stark von der Art, Form und Beschaffenheit der Oberfläche der elektrischen Baugruppe bzw. des darauf befindlichen Objekts ab.

In einem dritten Verfahrensschritt S3 wird das reflektierte Radarsignal mittels einer Radarsignalempfangseinrichtung, die wenigstens eine Empfangsantenne zum Empfangen des reflektierten Radarsignals umfasst, empfangen.

In einem vierten Verfahrensschritt S4 wird das von der Radarsignalempfangseinrichtung empfangene, reflektierte Radarsignal einer Radarsignalauswerteeinrichtung zugeführt, die wenigstens einen Signalprozessor zum Auswerten dieses Signals umfasst zum Erkennen einer bei der elektrischen Baugruppe vorliegenden Verschmutzung.

In einem fünften Verfahrensschritt S5 wird von der Radarsignalauswerteeinrichtung gegebenenfalls ein Warnhinweis erzeugt, der einen Benutzer über eine festgestellte Verschmutzung der elektrischen Baugruppe informiert.

## Patentansprüche

1. Verfahren zum Überwachen einer elektrischen Baugruppe (10, 21) hinsichtlich Verschmutzung mittels eines Radars (1, 25), wobei
- eine Radarsignalerzeugungseinrichtung ein Radarsignal (29) erzeugt und mittels einer Radarsignalsendeeinrichtung in Richtung einer von der elektrischen Baugruppe (10, 21) umfassten Oberfläche aussendet,
- wobei das Radarsignal (29) an der Oberfläche oder einem auf der Oberfläche befindlichen Objekt reflektiert wird,
- wobei eine Radarsignalempfangseinrichtung ein reflektiertes Radarsignal (32) empfängt und wobei
- eine Radarsignalauswerteeinrichtung das von der Radarsignalempfangseinrichtung empfangene, reflektierte Radarsignal (32) auswertet zum Erkennen einer bei der elektrischen Baugruppe (10, 21) vorliegenden Verschmutzung,
- wobei das Radar (1, 25) nicht von der elektrischen Baugruppe (10, 21) umfasst ist und
- wobei das Radar über eine Datenverbindung mit einer externen Recheneinrichtung (20) verbunden ist, mittels der die von dem Radar (1) erzeugten Daten empfangen, gespeichert und gegebenenfalls weiterverarbeitet werden,
**dadurch gekennzeichnet, dass**
- die Verschmutzung der elektrischen Baugruppe (10, 21) über einen längeren Zeitraum, insbesondere Jahre, registriert und analysiert wird und
- die elektrische Baugruppe (10, 21) im laufenden Betrieb hinsichtlich Verschmutzung überprüft wird.

2. Verfahren nach Anspruch 1, wobei mittels der Radarsignalauswerteeinrichtung ein Vergleich mit Referenzdaten der unverschmutzten Oberfläche der elektrischen Baugruppe (10, 21) erfolgt.

3. Verfahren nach Anspruch 1 oder 2, wobei das Radar (1, 25) als UWB-Radar, als Millimeter-Radar oder als Infrarot-Radar ausgebildet ist.

4. Verfahren nach einem der vorherigen Ansprüche, wobei das Radar einen in sich geschlossenen, integrierten Radar-IC umfasst.

5. Verfahren nach Anspruch 4, wobei das Radar-IC Sende- und/oder Empfangsantennen umfasst.

6. Verfahren nach einem der vorherigen Ansprüche, wobei das Radar (1, 25) ein Gehäuse (30) mit einem bezüglich des erzeugten Radarsignals (29) durchlässigen Gehäusebereich umfasst.

7. System mit einer elektrischen Baugruppe (10, 21) und einem Radar (1, 25) zum Überwachen der elektrischen Baugruppe (10, 21) hinsichtlich Verschmutzung, umfassend:
- eine Radarsignalerzeugungseinrichtung zum Erzeugen eines Radarsignals (29),
- eine Radarsignalsendeeinrichtung zum Senden des Radarsignals (29) in Richtung einer von der elektrischen Baugruppe (10, 21) umfassten Oberfläche,
- eine Radarsignalempfangseinrichtung zum Empfangen eines in Folge des gesendeten Radarsignals (29) an der Oberfläche oder einem auf der Oberfläche befindlichen Objekt reflektierten Radarsignals (32),
- eine Radarsignalauswerteeinrichtung zum Auswerten des von der Radarsignalempfangseinrichtung empfangenen, reflektierten Radarsignals (32) und zum Erkennen einer bei der elektrischen Baugruppe (10, 21) vorliegenden Verschmutzung,
- wobei das Radar (1, 25) nicht von der elektrischen Baugruppe (10, 21) umfasst ist und
- wobei das Radar über eine Datenverbindung mit einer externen Recheneinrichtung (20) verbunden ist, mittels der die von dem Radar (1) erzeugten Daten empfangen, gespeichert und gegebenenfalls weiterverarbeitet werden,
**dadurch gekennzeichnet, dass** das Radar eingerichtet ist,
- die Verschmutzung der elektrischen Baugruppe (10, 21) über einen längeren Zeitraum, insbesondere Jahre, zu registrieren und zu analysieren und
- die elektrische Baugruppe (10, 21) im laufenden Betrieb hinsichtlich Verschmutzung zu überprüfen.

8. System nach Anspruch 7, wobei das Radar (1,25) ausgebildet ist als UWB-Radar, als Millimeter-Radar oder als Infrarot-Radar.

9. System nach Anspruch 7 oder 8, wobei das Radar einen in sich geschlossenen, integrierten Radar-IC umfasst oder als in sich geschlossener, integrierter Radar-IC ausgebildet ist.

10. System nach Anspruch 9, wobei das Radar-IC Sende- und/oder Empfangsantennen umfasst.

11. System nach einem der Ansprüche 7 bis 10, wobei das Radar (1, 25) ein Gehäuse (30) mit einem bezüglich des erzeugten Radarsignals (29) durchlässigen Gehäusebereich umfasst.

## Claims

1. Method for monitoring an electrical assembly (10, 21) with regard to contamination by means of a radar (1, 25), wherein
- a radar signal generation facility generates a radar signal (29) and, by means of a radar signal transmit facility, emits it in the direction of a surface comprised by the electrical assembly (10, 21),
- wherein the radar signal (29) is reflected on the surface or an object located on the surface,
- wherein a radar signal receive facility receives a reflected radar signal (32) and wherein
- a radar signal evaluation facility evaluates the reflected radar signal (32) received by the radar signal receive facility in order to identify a contamination present in the electrical assembly (10, 21),
- wherein the radar (1, 25) is not comprised by the electrical assembly (10, 21), and
- wherein the radar is connected via a data connection to an external computing facility (20), by means of which the data generated by the radar (1) can be received, stored and possibly further processed,
**characterised in that**
- the contamination of the electrical assembly (10, 21) is registered and analysed over a longer period of time, in particular years, and
- the electrical assembly (10, 21) is reviewed with regard to contamination during ongoing operation.

2. Method according to claim 1, wherein a comparison with reference data of the uncontaminated surface of the electrical assembly (10, 21) takes place by means of the radar signal evaluation facility.

3. Method according to claim 1 or 2, wherein the radar (1, 25) is embodied as a UWB radar, a millimetre radar or an infrared radar.

4. Method according to one of the preceding claims, wherein the radar comprises an intrinsically closed, integrated radar IC.

5. Method according to claim 4, wherein the radar IC comprises transmit and/or receive antennas.

6. Method according to one of the preceding claims, wherein the radar (1, 25) comprises a housing (30) with a housing region that allows the generated radar signal (29) to pass through.

7. System with an electrical assembly (10, 21) and a radar (1, 25) for monitoring the electrical assembly (10, 21) with regard to contamination, comprising:
- a radar signal generation facility for generating a radar signal (29),
- a radar signal transmit facility for transmitting the radar signal (29) in the direction of a surface comprised by the electrical assembly (10, 21),
- a radar signal receive facility for receiving a radar signal (32) reflected on the surface or an object located on the surface as a result of the transmitted radar signal (29),
- a radar signal evaluation facility for evaluating the reflected radar signal (32) received by the radar signal receive facility and for identifying a contamination present in the electrical assembly (10, 21),
- wherein the radar (1, 25) is not comprised by the electrical assembly (10, 21), and
- wherein the radar is connected via a data connection to an external computing facility (20), by means of which the data generated by the radar (1) can be received, stored and possibly further processed,
**characterised in that** the radar is configured
- to register and analyse the contamination of the electrical assembly (10, 21) over a longer period of time, in particular years, and
- to review the electrical assembly (10, 21) with regard to contamination during ongoing operation.

8. System according to claim 7, wherein the radar (1, 25) is embodied as a UWB radar, a millimetre radar or an infrared radar.

9. System according to claim 7 or 8, wherein the radar comprises an intrinsically closed, integrated radar IC or is embodied as an intrinsically closed, integrated radar IC.

10. System according to claim 9, wherein the radar IC comprises transmit and/or receive antennas.

11. System according to one of claims 7 to 10, wherein the radar (1, 25) comprises a housing (30) with a housing region that allows the generated radar signal (29) to pass through.

## Revendications

1. Procédé de contrôle au moyen d'un radar (1, 25) de la salissure d'un module (10, 21) électrique, dans lequel
- un dispositif de production de signal radar produit un signal (29) radar et, au moyen d'un dispositif d'envoi d'un signal radar, l'envoie en direction d'une surface comprise par le module (10, 21) électrique,
- dans lequel le signal (29) radar est réfléchi sur la surface ou sur un objet se trouvant sur la surface,
- dans lequel un dispositif de réception d'un signal radar reçoit un signal (32) radar réfléchi et dans lequel
- un dispositif d'évaluation d'un signal radar évalue le signal (32) radar réfléchi, reçu par le dispositif de réception d'un signal radar, pour l'identification d'une salissure présente sur le module (10, 21) électrique,
- dans lequel le radar (1, 25) n'est pas compris par le module (10, 21) électrique et
- dans lequel le radar est relié par une liaison de données à un dispositif (20) informatique extérieur, au moyen duquel les données produites par le radar (1) sont reçues, mises en mémoire et le cas échéant retraitées,
**caractérisé en ce que**
- la salissure du module (10, 21) électrique est enregistrée et analysée sur un laps de temps assez long, en particulier sur des années et
- on contrôle le module (10, 21) électrique en ce qui concerne la salissure en fonctionnement continu.

2. Procédé suivant la revendication 1, dans lequel, au moyen du dispositif d'évaluation d'un signal radar, il s'effectue une comparaison à des données de référence de la surface non salie du module (10, 21) électrique.

3. Procédé suivant la revendication 1 ou 2, dans lequel le radar (1, 25) est constitué en radar UWB, en radar millimétrique ou en radar infrarouge.

4. Procédé suivant l'une des revendications précédentes, dans lequel le radar comprend un radar-CI intégré en soi fermé.

5. Procédé suivant la revendication 4, dans lequel le radar-CI comprend des antennes d'émission et/ou de réception.

6. Procédé suivant l'une des revendications précédentes, dans lequel le radar (1, 25) comprend un boîtier (30) ayant une partie de boîtier transparente au signal (29) radar produit.

7. Système comprenant un module (10, 21) électrique à radar (1, 25) de contrôle de la salissure du module (10, 21) électrique, comprenant :
- un dispositif de production d'un signal radar pour la production d'un signal (29) radar,
- un dispositif d'envoi d'un signal radar pour l'envoi du signal (29) radar en direction d'une surface comprise par le module (10, 21) électrique,
- un dispositif de réception d'un signal (32) radar réfléchi en raison du signal (29) radar envoyé sur la surface ou sur un objet se trouvant sur la surface,
- un dispositif d'évaluation d'un signal radar pour l'évaluation du signal (32) radar réfléchi reçu par le dispositif de réception d'un signal radar et pour l'identification d'une salissure se trouvant sur le module (10, 21) électrique,
- dans lequel le radar (1, 25) n'est pas compris par le module (10, 21) électrique et
- dans lequel le radar est relié par une liaison de données à un dispositif (20) informatique extérieur, au moyen duquel les données produites par le radar (1) sont reçues, mises en mémoire et le cas échéant retraitées,
**caractérisé en ce que** le radar est agencé pour
- créer et analyser la salissure du module (10, 21) électrique sur un laps de temps assez grand, en particulier sur des années, et
- contrôler le module (10, 21) électrique en ce qui concerne la salissure en fonctionnement continu.

8. Système suivant la revendication 7, dans lequel le radar (1, 25) est constitué en radar UWB, en radar millimétrique ou en radar infrarouge.

9. Système suivant la revendication 7 ou 8, dans lequel le radar comprend un radar-CI intégré en soi fermé ou est constitué sous la forme d'un radar-CI intégré en soi fermé.

10. Système suivant la revendication 9, dans lequel le radar-CI comprend des antennes d'émission et/ou de réception.

11. Système suivant l'une des revendications 7 à 10, dans lequel le radar (1, 25) comprend un boîtier (30) ayant une partie de boîtier transparente en ce qui concerne le signal (29) radar produit.
